# EUROPEAN PATENT APPLICATION

(11) **EP 2 750 208 A2**
(43) Date of publication of application: **02.07.2014**
(21) Application number: 12826450.4
(22) Date of filing: 22.08.2012
(51) Int. Cl.: H01L 33/48

(54) **LIGHT-EMITTING ELEMENT FOR HIGH-CURRENT DRIVE**

(30) Priority: 25.08.2011 KR 20110085288
(71) Applicant: Seoul Viosys Co., Ltd., Gyeonggi-do 425-851 (KR)
(72) Inventor: YE, Kyung Hee, Ansan-si Gyeonggi-do 425-851 (KR); CHO, Dae Sung, Ansan-si Gyeonggi-do 425-851 (KR); NAM, Ki Bum, Ansan-si Gyeonggi-do 425-851 (KR)
(74) Representative: Stolmár & Partner
(86) International application number: PCT/KR2012/006648
(87) International publication number: WO 2013/028000

(57) **Abstract**

Disclosed is a light-emitting element for high-current drive. The light-emitting element comprises: a light-emitting diode chip which emits ultraviolet light; and a wavelength conversion layer which converts the wavelength of the ultraviolet light emitted from the light-emitting diode chip into visible light. The light-emitting diode chip is driven at a current density of at least 150 A/cm².

## Description

### [Technical Field]

The present invention relates to a light emitting device and, more particularly, to a light emitting device for high current operation.

### [Background Art]

Light emitting diodes, particularly, nitride-based light emitting diodes, are used as light sources for emitting ultraviolet or blue light and are applied to various fields, such as signboards, backlight units, headlights of vehicles, lighting fixtures, and the like.

Particularly, a desired color, for example, white light, can be realized through combination of a light emitting diode and phosphors. For example, it is well known in the art that white light can be obtained by combination of a light emitting diode emitting blue light and yellow phosphors converting blue light into yellow light.

A white light emitting device has luminous efficacy similar or superior to that of typical fluorescent lamps. Furthermore, light emitting devices are more eco-friendly than fluorescent lamps. Thus, in order to reduce power consumption and ensure eco-friendliness, a light emitting device employing a light emitting diode is used in place of the fluorescent lamps as a light source in the art and will be used in a broader application range.

However, in order to use the light emitting device as a light source, for example, as a white light source, not only luminous efficacy of a light emitting device per se but also luminous efficacy per cost must be taken into account. That is, it is necessary to reduce manufacturing costs while improving optical output of the light emitting device. In order to improve luminous efficacy per cost, it is necessary to operate a light emitting device under high current conditions. Assuming that increase in electric current provides a linear increase of light output, luminous efficacy per cost can also be increased due to the increase in current.

However, as the amount of electric current applied to the light emitting diode increases, that is, as current density increases, there is a phenomenon wherein external quantum efficiency of the light emitting diode decreases. Such a phenomenon is known as droop. Since increase in current density applied to the light emitting diode causes decrease in external quantum efficiency, the effect of operating the light emitting device at high current cannot be obtained.

Moreover, increase in operation current causes variation of wavelengths of light emitted from the light emitting diode. Since variation of the wavelengths of light emitted from a blue light emitting diode influences color temperature and color rendition of the light emitting device, a white light emitting device having desired color temperature and color rendition cannot be achieved simply by increasing current in a typical light emitting diode which is operated at a relatively low current.

### [Disclosure]

### [Technical Problem]

Exemplary embodiments of the present invention provide a light emitting device having excellent luminous efficacy per cost.

Exemplary embodiments of the present invention also provide a light emitting device capable of reducing variation in color temperature or color rendition due to increase in electric current.

Exemplary embodiments of the present invention also provide a method of operating a light emitting device capable of improving luminous efficacy per cost.

### [Technical Solution]

An exemplary embodiment of the present invention a light emitting device. The light emitting device includes a UV light emitting diode chip; and a wavelength conversion layer converting UV light emitted from the UV light emitting diode chip into visible light through wavelength conversion, wherein the light emitting diode chip is operated at a current density of 150 A/cm² or more.

When operated at a current density of about 150 A/cm² or more, the UV light emitting diode chip exhibits higher external quantum efficiency than a blue light emitting diode chip. In addition, the UV light emitting diode chip less suffers from droop than the blue light emitting diode chip. Further, since UV light does not affect visibility even in the case where wavelengths of light emitted from the UV light emitting diode chip are shifted due to increase in current density, there is no significant variation in color temperature or color rendition.

An upper limit of current density applied to the light emitting diode chip is not particularly limited so long as the current density can secure stable operation of the light emitting device. For example, the light emitting diode chip may have a current density of less than 300 A/cm².

The UV light emitting diode chip may be a light emitting diode chip emitting UV light in a wavelength range from 280 nm to 400 nm, particularly, a light emitting diode chip emitting near-UV light in a wavelength range from 380 nm to 400 nm.

The wavelength conversion layer may contain blue phosphors, green phosphors, and red phosphors. In addition, the wavelength conversion layer may include a first wavelength conversion layer containing red phosphors, a second wavelength conversion layer containing green phosphors, and a third wavelength conversion layer containing blue phosphors.

The wavelength conversion layer may be separated from the light emitting diode chip and may further include a selective reflector disposed between the wavelength conversion layer and the light emitting diode chip. The selective reflector allows UV light emitted from the light emitting diode chip to pass therethrough while reflecting visible light subjected to wavelength conversion by the wavelength conversion layer.

The light emitting device may include at least three UV light emitting diode chips. Here, the wavelength conversion layer may include a first wavelength conversion layer containing red phosphors, a second wavelength conversion layer containing green phosphors, and a third wavelength conversion layer containing blue phosphors, and the first to third wavelength conversion layers may cover the at least three light emitting diode chips, respectively.

In some embodiments, the wavelength conversion layer may include a first wavelength conversion region containing red phosphors, a second wavelength conversion region containing green phosphors, and a third wavelength conversion region containing blue phosphors. The first to third wavelength conversion regions may be disposed above the at least three light emitting diode chips, respectively.

The light emitting device may further include a UV filter which allows visible light subjected to wavelength conversion by the wavelength conversion layer to pass therethrough while blocking UV light emitted from the light emitting diode chip. The UV filter blocks UV light from being emitted outside the light emitting device.

An exemplary embodiment of the present invention provides a method of using a light emitting device. The method includes connecting an external power source to a light emitting device, which includes a UV light emitting diode chip and a wavelength conversion layer converting UV light emitted from the UV light emitting diode chip into visible light through wavelength conversion, and operating the light emitting diode chip by supplying electric current to the light emitting device such that a current density of 150 A/cm² or more is applied to the light emitting diode chip.

### [Advantageous Effects]

According to embodiments of the present invention, a light emitting device including a UV light emitting diode chip is operated at high current density to provide higher external quantum efficiency of the UV light emitting diode chip than that of a blue light emitting diode chip, thereby improving luminous efficacy per cost. Furthermore, the light emitting device includes the UV light emitting diode chip, thereby reducing variation in color temperature or color rendition due to increase in current.

### [Description of Drawings]

Figure 1 is a graph depicting variation of external quantum efficiency upon increase in current density of a blue light emitting diode chip and a UV light emitting diode chip.
Figure 2 is a graph depicting droop of various light emitting diode chips.
Figure 3 is a sectional view of a light emitting device 100 in accordance with one embodiment of the present invention.
Figure 4 is a sectional view of a light emitting device 200 in accordance with another embodiment of the present invention.
Figure 5 is a sectional view of a light emitting device 300 in accordance with a further embodiment of the present invention.
Figure 6 is a sectional view of a light emitting device 400 in accordance with yet another embodiment of the present invention.

### [Best Mode]

Hereinafter, embodiments of the present invention will be described in more detail with reference to the accompanying drawings. It should be understood that the following embodiments are given by way of illustration only to provide thorough understanding of the invention to those skilled in the art. Therefore, the present invention is not limited to the following embodiments and may be embodied in different ways. Further, the widths, lengths, and thicknesses of certain elements, layers or features may be exaggerated for clarity, and like components will be denoted by like reference numerals throughout the specification.

Herein, 'current density' of a light emitting diode chip means a value calculated by dividing electric current applied to the light emitting diode chip by an external area of the light emitting diode chip. Thus, actual current density applied to an activation area can be higher than the calculated 'current density' due to reduction in activation area by mesa etching or patterning.

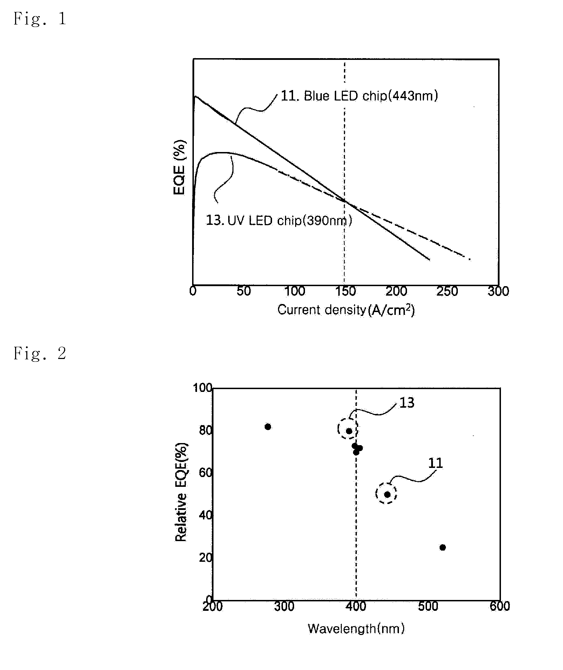

Figure 1 is a graph depicting variation of external quantum efficiency upon increase in current density of a blue light emitting diode chip and a UV light emitting diode chip.

Each of light emitting diode chips 11, 13 are fabricated by growing a gallium nitride-based compound semiconductor layer on a sapphire substrate, and has a multi-quantum well structure of InGaN well layers/GaN barrier layers. Further, in each of the light emitting diode chips 11, 13, the GaN barrier layer has a thickness of about 7 nm. On the other hand, the InGaN well layer of the blue light emitting diode chip 11 has an indium molar ratio of 0.2 and a thickness of about 3 nm, and the InGaN well layer of the UV light emitting diode chip 13 has an indium molar ratio of about 0.1 and a thickness of about 3.3 nm. Each of the light emitting diode chips 11, 13 may have a size of about 1 mm x 1 mm.

The blue light emitting diode chip 11 emits blue light having a peak wavelength of about 443 nm at maximum efficiency, and UV light emitting diode chip 13 emits UV light having a peak wavelength of about 390 nm at maximum efficiency.

Referring to Figure 1, although the blue light emitting diode chip 11 has higher maximum luminous efficacy than the UV light emitting diode chip 13, the blue light emitting diode chip 11 suffers from rapid reduction in external quantum efficiency as current density increases. On the contrary, the UV light emitting diode chip 13 undergoes smoother reduction in external quantum efficiency upon increase in current density than the blue light emitting diode chip 11. At a current density of about 150 A/cm², the blue light emitting diode chip 11 and the UV light emitting diode chip 13 exhibit the same external quantum efficiency and, at a current density exceeding 150 A/cm², the external quantum efficiency of the UV light emitting diode chip 13 is higher than that of the blue light emitting diode chip 11.

Accordingly, it can be seen that the light emitting device operated at a current density of about 150 A/cm² or more is more advantageous in terms of luminous efficacy than the blue light emitting diode chip, when adopting the UV light emitting diode chip.

Figure 2 is a graph depicting droop of various light emitting diode chips. Here, the light emitting diode chips are fabricated using GaN-based compound semiconductors and are commercially available. For each of the light emitting diode chips, the ratio of external quantum efficiency at a current density of 150 A/cm² to maximum external quantum efficiency is represented by percent.

Referring to Figure 2, the UV light emitting diode chips (including the UV light emitting diode chip 13) emitting UV light having wavelengths of about 390 nm or less exhibited external quantum efficiency which is about 80% of the maximum external quantum efficiency even in the case where current density increases, and the near-UV light emitting diode chips emitting UV light having wavelengths near about 400 nm exhibited external quantum efficiency which is about 70% of the maximum external quantum efficiency. On the other hand, the blue light emitting diode chip 11 and the green light emitting diode chip exhibited external quantum efficiency which is about 50% or less of the maximum external quantum efficiency.

As a result, it can be seen that the light emitting diode chip emitting light having a wavelength of 400 nm or less exhibits higher luminous efficacy at high current density than the blue light emitting diode chip 11.

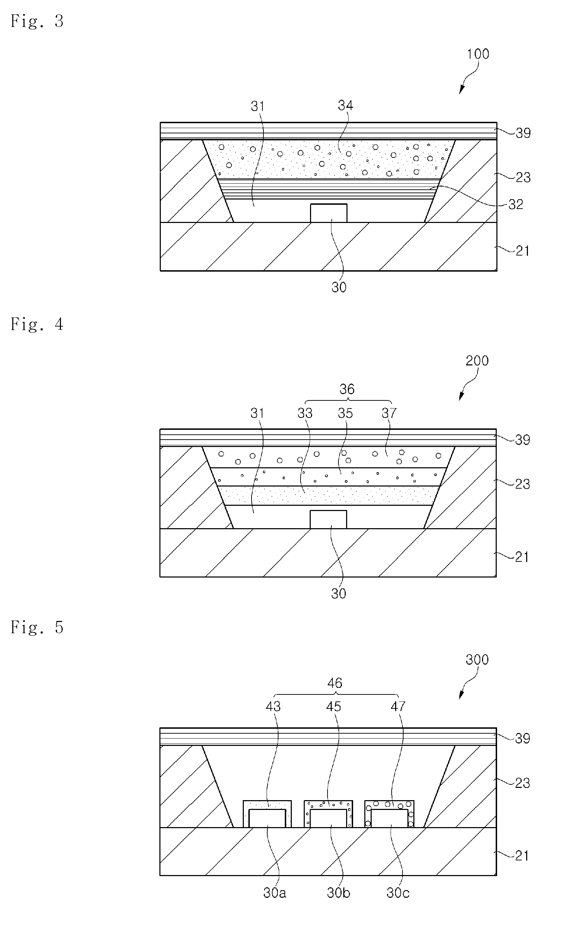

Figure 3 is a sectional view of a light emitting device 100 in accordance with one embodiment of the present invention.

Referring to Figure 3, the light emitting device 100 includes a substrate 21, a housing 23, a light emitting diode chip 30, a selective reflector 32, a wavelength conversion layer 34, and a UV filter 39.

The substrate 21 supports the light emitting diode chip 30 and is provided with lead terminals (not shown) that supply electric current to the light emitting diode chip 30. Specifically, the substrate 21 has lead terminals and/or a wiring structure adapted to supply high current, for example, a current density of 150 A/cm² or more, to the light emitting diode chip 30. For the substrate 21, any kind of substrate can be used without limitation so long as the substrate can support the light emitting diode chip 30 while connecting the light emitting diode chip 30 to an external power source. For example, the substrate 21 may be a printed circuit board or a lead frame.

The housing 23 encloses the light emitting diode chip 30. The housing 23 may act as a reflector. The housing 23 may be fabricated separately from and then attached to the substrate 21, or the housing 23 may be integrally formed with the substrate 21 like a package body of a lead frame.

The light emitting diode chip 30 is attached to an upper surface of the substrate 21. The light emitting diode chip 30 is a UV light emitting diode chip 30, which is fabricated from, for example, a gallium nitride based compound semiconductor. The UV light emitting diode chip 30 may be formed by sequentially stacking an n-type semiconductor layer, an active layer and a p-type semiconductor layer on a growth substrate such as a sapphire substrate, wherein the active layer is formed between the n-type semiconductor layer and the p-type semiconductor layer and has a multi-quantum well structure formed by stacking well layers and barrier layers. The well layer may be an InGaN layer or a GaN layer, and the barrier layer may be a GaN layer or an AlGaN layer. In addition, the light emitting diode chip may include an electron blocking layer of AlGaN. The light emitting diode chip 30 may emit UV light in a wavelength range from 280 nm to 400 nm, particularly, near UV light in a wavelength range from 380 nm to 400 nm.

The wavelength conversion layer 34 is disposed above the light emitting diode chip 30. The wavelength conversion layer 34 performs wavelength conversion of UV light into visible light when the UV light is emitted from the light emitting diode chip 30. The wavelength conversion layer 34 may contain white phosphors, or blue phosphors, and/or green phosphors and/or red phosphors. Accordingly, various colors, particularly, white light, may be realized by light subjected to wavelength conversion through the wavelength conversion layer 34.

For example, the white phosphors may include 3Ca₃(PO₄)₂·Ca(F, Cl)₂:Sb, YVO₄:Dy, Y₂O₂S:Tb, Sm, (Zn, Cd)S:Au, Ag, Al.

Examples of the blue phosphors may include (Sr, Ca, Ba, Mg)₅(PO₄)₃Cl:Eu, (Sr, Ca, Mg)₅(PO₄)₃Cl:Eu, (Ba, Ca)₅(PO₄)₃Cl:Eu, Sr₅(PO₄)₃Cl:Eu, Sr₃(PO₄)₂:Eu, (Sr, Mg)₂P₂O₇:Eu, Sr₂P₂O₇:Eu, Sr₂P₂O₇:Sn, Ba₂P₂O₇:Ti, (Sr, Ca)₁₀(PO₄)₆Cl₂·B₂O₃:Eu, (Sr, Mg)₃(PO₄)₂:Cu, 2SrO·P₂O₅. B₂O₃:Eu, (Ba, Mg)Si₂O₅:Eu, (Sr, Ba)Al₂Si₂O₈:Eu, Ba₃MgSi₂O₈:Eu, Sr₂Si₃O₈·2SrCl₂:Eu, Zn₂SiO₄:Ti, BaAl₈O₁₃:Eu, BaMg₂Al₆O₂₇:Eu, Mn, CaAl₂O₄:Eu, Nd, Sr₄Al₁₄O₂₅:Eu, SrMgAl₁₀O₁₇:Eu, BaMgAl₁₀O₁₇:Eu, SrAl₄O₇:Eu, Dy, Sr₄Al₁₄O₂₅:Eu, Dy, CaWO₄, CaWO₄:Pb, MgWO₄. ZnS:Ag, Ni, ZnS:Ag, Cl, ZnS:Ag, Cu, ZnS:Ag, Fe, Al, ZnS:Cu, Ag, Cl, ZnS:Cu, Au, Al, ZnS:Tm, ZnS:Pb, Cu, ZnS:Zn, ZnS:Zn, Ga, ZnGa₂O₄, Zn(S, Se):Ag, (Zn, Cd)S:Ag, Ni, (Zn, Cd)S:Ag, Al, Y₂SiO₅:M¹ (provided that M¹ is at least one selected from Tm and Ce), (Ca, Mg)SiO₃:Ti, CaF₂:Eu, M²₂O₂S:Tm (provided that M² is at least one selected from Y, La, Gd and Lu), M²OX:Ce (provided that M² is at least one selected from Y, La, Gd and Lu, and X is at least one selected from Br and Cr), (M², M³)TaO₄:Nb (provided that M² is at least one selected from Y, La, Gd and Lu, and M³ is at least one selected from Mg, Ca, Sr and Ba), (M¹, Eu)₁₀(PO₄)₆·Cl₂ (provided that M¹ is at least one selected from Mg, Ca, Sr and Ba), and a(M², Eu)O·bAl₂O₃ (provided that M² is at least one selected from Mg, Ca, Sr, Ba, Zn, Li, Rb and Cs, a>0, b>0, 0.2≤a/b≤1.5).

Examples of the green phosphors may include BaAl₁₂O₁₉:Mn, Ca₁₀(PO₄)₆F₂:Sb, Mn, CeMgAl₁₁O₁₉:Tb, GdMgB₅O₁₀:Ce, Tb, La₂O₃·0.2SiO₂·0.9P₂O₅:Ce, Tb, MgAl₁₁O₁₉:Ce, Tb, Mn, MgGa₂O₄:Mn, SrAl₂O₄:Eu, SrAl₂O₄:Eu, Dy, Y₂O₃·Al₂O₃:Tb, Y₂SiO₅:Ce, Tb, YBO₃:Tb, Zn₂GeO₄:Mn, Sr₅(PO₄)₃F:Sb, BaMg₂Al₁₆O₂₇:Eu, Mn, ZnS:Au, Al, ZnS:Cu, Au, Al, ZnS:Cu, Cl, Zn(S, Se):Ag, (Zn, Cd)S:Ag, Cl, (Zn, Cd)S:Au, Al, (Zn, Cd)S:Au, Cu, Al, (Zn, Cd)S:Cu, Al, (Zn, Cd)S:Cu, Cl, (Zn, Cd)S:Ag, Ni, ZnO:Zn, M²₂O₂S:Tb (provided that M² is at least one selected from Y, La, Gd and Lu), M²₂O₂S:Pr (provided that M² is at least one selected from Y, La, Gd and Lu), M²OX:Tb (provided that M² is at least one selected from Y, La, Gd and Lu, and X is at least one selected from Br and Cr), InBO₃:Tb, Li₅Zn₈Al₅(GeO₄)₄:Mn, SrGa₂S₄:Eu, Y₂(Si, Ge)O₅:Tb, Y₂SiO₅:Pr, Y₂SiO₅:Tb, Y₃Al₅O₁₂:Cr, Tb, Y₃(Al, Ga)₅O₁₂:Tb, Y₃Al₅O₁₂:Tb, YF₃:Er, Zn₂SiO₄:Mn, Zn₂SiO₄:Mn, Al, Zn₂SiO₄:Mn, As, (M², M³)TaO₄:Tb (provided that M² is at least one selected from Y, La, Gd and Lu, and M³ is at least one selected from Mg, Ca, Sr and Ba), and (Ba_{1-x-y-z}SrₓCa_{y}Eu_{z})(Mg₁₋ᵤMnᵤ)Al₁₀O₁₇ (0≤x<0.2, 0≤y<0.1, 0.005<z<0.5, 0.1<u<0.5).

Examples of the red phosphors may include M²BO₃:Eu (provided that M² is at least one selected from Y, La, Gd and Lu), (Sr, Mg)₃(PO₄)₂:Sn, Mg₆As₂O₁₁:Mn, CaSiO₃:Pb, Mn, Cd₂B₂O₅:Mn, YVO₄:Eu, (Ca, Zn, Mg)₃(PO₄)₂:Sn, (Ce, Gd, Tb)MgB₅O₁₀:Mn, Mg₄FGeO₆:Mn, Mg₄F(Ge, Si)O₆:Mn, SrTiO₃:Pr, Al, CaTiO₃:Eu, Gd₂O₃:Eu, (Gd, M⁴)₂O₃:Eu (provided that M⁴ is at least one selected from Y, La and Lu), Gd₂O₂S:Eu, (Gd, M⁴)₂O₂S:Eu (provided that M⁴ is at least one selected from Y, La and Lu), M²₂O₂S:Eu, Mg, M⁵ (provided that M² is at least one selected from Y, La, Gd and Lu, and M⁵ is at least one selected from Ti, Nb, Ta and Ga), MgF₂:Mn, (KF, MgF₂:Mn, (Zn, Be)₂SiO₄:Mn, Zn₃(PO₄)₂:Mn, (Zn, Ca)₃(PO₄)₂:Mn, (Zn, Cd)S:Ag, Cl, (Zn, Cd)S:Cu, Al, (Zn, Cd)S:Cu, Cl, (Zn, Mg)F₂:Mn, CaSiO₃:Pb, Mn, Cd₅Cl(PO₄)₃:Mn, InBO₃:Eu, MgGeO₄:Mn, MgSiO₃:Mn, SnO₂:Eu, YVO₄:Eu, ZrO₂:Eu, (M², M³)TaO₄:Eu (provided that M² is at least one selected from Y, La, Gd and Lu, and M³ is at least one selected from Mg, Ca, Sr and Ba), (La_{1-x-y}EuₓM_{y})₂O₂S (provided that M is at least one selected from Sb, Sm, Ga and Sn, 0.01<x<0.15, 0≤y<0.03), and (SrₓCa₁₋ₓ)SiAlN₃:Eu) (0≤x<0.4).

The selective reflector 32 is disposed between the UV light emitting diode chip 30 and the wavelength conversion layer 34. The selective reflector 32 allows UV light emitted from the light emitting diode chip 32 to pass therethrough while reflecting visible light subjected to wavelength conversion through the wavelength conversion layer 34. Thus, the selective reflector reflects light, which is subjected to wavelength conversion through the wavelength conversion layer 34 and travels towards the substrate 21, to the outside of the light emitting device, thereby improving luminous efficacy.

The selective reflector 32 may be formed as a Bragg reflector having wavelength selectivity by repeatedly stacking dielectric layers having different indexes of reflection. In addition, a transparent resin 31 may be disposed between the selective reflector 32 and the light emitting diode chip 30 to cover the light emitting diode chip 30.

The UV filter 39 may be disposed on the wavelength conversion layer 34. The UV filter 39 blocks UV light emitted outside from the wavelength conversion layer 34 while allowing visible light to pass therethrough. With this structure, it is possible to prevent a human body or external articles from being damaged by UV light. The UV filter 39 may be formed by repeatedly stacking dielectric layers having different indexes of refraction to reflect or absorb UV light while allowing the visible light emitted from the wavelength conversion layer 34 to pass therethrough.

Figure 4 is a sectional view of a light emitting device 200 in accordance with another embodiment of the present invention.

Referring to Figure 4, the light emitting device 200 according to this embodiment is generally similar to the light emitting device 100 illustrated in Figure 3 except that a wavelength conversion layer 36 includes a plurality of wavelength conversion layers. That is, the wavelength conversion layer 36 includes a first wavelength conversion layer 33 containing red phosphors, a second wavelength conversion layer 35 containing green phosphors, and a third wavelength conversion layer 37 containing blue phosphors. The red phosphors, green phosphors and blue phosphors may be the same as those in the embodiment shown in Figure 3.

Among the plural wavelength conversion layers, a wavelength conversion layer converting wavelengths of UV light into visible light having longer wavelengths may be disposed near the light emitting diode chip. For example, as shown in Figure 4, the first wavelength conversion layer 33 containing the red phosphors may be disposed closer to the light emitting diode chip 30 than the second and third wavelength conversion layers 35, 37, and the second wavelength conversion layer 35 containing the green phosphors may be disposed more adjacent to the light emitting diode chip 30 than the third wavelength conversion layer 37 containing blue phosphors.

In this embodiment, since the wavelength conversion layers are divided according to spectrum regions of visible light, the wavelength conversion layer 36 having more uniform characteristics can be more easily formed than the wavelength conversion layer 34 of Figure 3, which is formed by mixing various kinds of phosphors.

Although the selective reflector 32 of Figure 3 is not illustrated, the light emitting device according to this embodiment may also include the selective reflector 32 disposed between the first wavelength conversion layer 33 and the light emitting diode chip 30, as described with reference to Figure 3.

Figure 5 is a sectional view of a light emitting device 300 in accordance with a further embodiment of the present invention.

Referring to Figure 5, the light emitting device 300 according to this embodiment may include a substrate 21, a housing 23, and a UV filter 39, as illustrated in Figure 3, and detailed descriptions thereof will be omitted.

In this embodiment, a plurality of light emitting diode chips 30a, 30b, 30c is attached to an upper surface of the substrate 21. These light emitting diode chips 30a, 30b, 30c are UV light emitting diode chips, as illustrated in Figure 3.

A wavelength conversion layer 46 includes a first wavelength conversion layer 43 containing red phosphors, a second wavelength conversion layer 45 containing green phosphors, and a third wavelength conversion layer 47 containing blue phosphors.

The light emitting diode chips 30a, 30b, 30c are covered by the first to third wavelength conversion layers 43, 45, 47, respectively. For example, the first wavelength conversion layer 43 containing the red phosphors may cover the light emitting diode chip 30a, the second wavelength conversion layer 45 containing the green phosphors may cover the light emitting diode chip 30b, and the third wavelength conversion layer 47 containing the blue phosphors may cover the light emitting diode chip 30c. These first to third wavelength conversion layers 43, 45, 47 may be pre-formed on the light emitting diode chips 30a, 30b, 30c by conformal coating before the light emitting diode chips 30a, 30b, 30c are attached to the substrate 21. Alternatively, the first to third wavelength conversion layers 43, 45, 47 may be formed on the corresponding light emitting diode chips after the light emitting diode chips 30a, 30b, 30c are attached to the substrate 21.

In addition, although not shown in the drawings, a selective reflector may be disposed between each of the wavelength conversion layers 43, 45, 47 and each of the light emitting diode chips 30a, 30b, 30c to reflect visible light while allowing UV light to pass therethrough.

In the embodiments shown in Figure 3 and Figure 4, the visible light subjected to wavelength conversion can be lost by different kinds of phosphors before being emitted to the outside. However, according to this embodiment, since the wavelength conversion layers 43, 45, 47 are separated from each other, the visible light subjected to wavelength conversion is prevented from being lost by different kinds of phosphors, thereby further improving luminous efficacy.

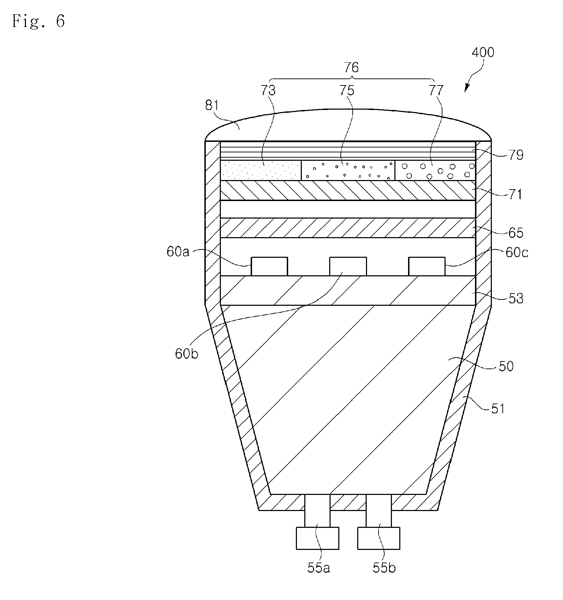

Figure 6 is a sectional view of a light emitting device 400 in accordance with yet another embodiment of the present invention.

Referring to Figure 6, the light emitting device 400 includes a printed circuit board 53, light emitting diode chips 60a, 60b, 60c, a wavelength conversion layer 76, a lens 81, a heat sink 50, a casing 51, and sockets 55a, 55b. In addition, although not shown in the drawings, a driving circuit may be disposed inside the heat sink 50 or on the printed circuit board 53.

The casing 51 defines an internal space. The casing 51 is formed at one side thereof with an opening, through which light is emitted to the outside.

To increase a surface area of the heat sink 50, the heat sink may have a convex-concave pattern. The heat sink 50 is partially exposed outside the casing 51. The heat sink 50 may be formed of a metal, for example, aluminum or aluminum alloys, which exhibits excellent heat dissipation.

The heat sink 50 may be formed with through-holes (not shown), through which covered electric wires (not shown) pass to connect the sockets 55a, 55b to the printed circuit board 53. The sockets 55a, 55b may be coupled to a lower side of the heat sink 50 by various socket bases, such as GU10 base, GZ10 base, and the like.

The printed circuit board 53 is thermally coupled to the heat sink 50. The printed circuit board 53 may be directly mounted on the heat sink 50. To this end, the heat sink 50 may be provided with a seat groove for receiving the printed circuit board 53.

The light emitting diode chips 60a, 60b, 60c are mounted on the printed circuit board 53. The printed circuit board 53 has a circuit pattern such that a current density of 150 A/cm² or more is applied to the light emitting diode chips 60a, 60b, 60c. In addition, when connected to an external power source, the driving circuit (not shown) connected to the printed circuit board 53 allows a current density of 150 A/cm² or more to be applied to the light emitting diode chips 60a, 60b, 60c.

Although the light emitting diode chips 60a, 60b, 60c may be mounted in chip form, the present invention is not limited to this structure. Alternatively, the light emitting diode chips may be mounted in package form. Like the light emitting diode chip 30 as shown in Figure 3, the light emitting diode chips 60a, 60b, 60c emit UV light.

The wavelength conversion layer 76 is disposed above the light emitting diode chips 60a, 60b, 60c. The wavelength conversion layer 76 may include a first wavelength conversion region 73 containing red phosphors, a second wavelength conversion region 75 containing green phosphors, and a third wavelength conversion region 77 containing blue phosphors. That is, the wavelength conversion layer 76 may be divided into the plurality of wavelength conversion regions 73, 75, 77. These first to third wavelength conversion regions 73, 75, 77 may be arranged to be disposed above the light emitting diode chips 60a, 60b, 60c, respectively. The red phosphors, green phosphors and blue phosphors may be the same as those described with reference to Figure 3.

In addition, a selective reflector 65 may be disposed between the wavelength conversion layer 76 and the light emitting diode chips 60a, 60b, 60c. Since the selective reflector 65 is similar to the selective reflector 32 described with reference to Figure 3, a detailed description thereof is omitted. Further, a UV filter 79 may be disposed above the wavelength conversion layer 76 as in the above embodiment, and thus, a detailed description thereof is omitted.

The light emitting device may further include a protective layer 71 under the wavelength conversion layer 76. The protective layer 71 may be formed of, for example, SiO₂ or a resin containing SiO₂ particles. The protective layer 71 protects the wavelength conversion layer 76 from being damaged by UV light emitted from the light emitting diode chips 60a, 60b, 60c.

The lens 81 is disposed above the wavelength conversion layer 76 and is configured to adjust an orientation angle of light emitted to the outside.

In this embodiment, the plural light emitting diode chips 60a, 60b, 60c are disposed on the printed circuit board 53. However, it should be understood that a single light emitting diode chip may be disposed thereon.

Furthermore, in this embodiment, the wavelength conversion layer 76 is separated from the light emitting diode chip 60a, 60b, 60c. However, it should be understood that, like the light emitting devices as shown in Figures 3 to 5, light emitting devices each having a wavelength conversion layer therein may be mounted on the printed circuit board 53. In this case, the wavelength conversion layer 76 can be omitted.

In use, the light emitting devices according to the embodiments as described above may be connected to an external power source to operate the light emitting diode chips by supplying electric current to the light emitting devices such that a current density of 150 A/cm² or more is applied to the light emitting diode chips.

Although some embodiments have been described above, it should be understood that the present invention is not limited to these embodiments and may be modified in various ways. In addition, technical features of a certain embodiment may also be applied to other embodiments.

## Claims

1. A light emitting device comprising:
a UV light emitting diode chip; and
a wavelength conversion layer converting UV light emitted from the UV light emitting diode chip into visible light through wavelength conversion,
wherein the light emitting diode chip is operated at a current density of 150 A/cm² or more.

2. The light emitting device of claim 1, wherein the UV light emitting diode chip emits UV light in a wavelength range from 280 nm to 400 nm.

3. The light emitting device of claim 1, wherein the wavelength conversion layer contains blue phosphors, green phosphors, and red phosphors.

4. The light emitting device of claim 1, wherein the wavelength conversion layer comprises a first wavelength conversion layer containing red phosphors, a second wavelength conversion layer containing green phosphors, and a third wavelength conversion layer containing blue phosphors.

5. The light emitting device of claim 1, wherein the wavelength conversion layer is separated from the light emitting diode chip.

6. The light emitting device of claim 5, further comprising:
a selective reflector disposed between the wavelength conversion layer and the light emitting diode chip, the selective reflector allowing UV light emitted from the light emitting diode chip to pass therethrough while reflecting visible light subjected to wavelength conversion by the wavelength conversion layer.

7. The light emitting device of claim 1, wherein the light emitting device comprises at least three UV light emitting diode chips.

8. The light emitting device of claim 7, wherein the wavelength conversion layer comprises a first wavelength conversion layer containing red phosphors, a second wavelength conversion layer containing green phosphors, and a third wavelength conversion layer containing blue phosphors, the first to third wavelength conversion layers covering the at least three light emitting diode chips, respectively.

9. The light emitting device of claim 7, wherein the wavelength conversion layer comprises a first wavelength conversion region containing red phosphors, a second wavelength conversion region containing green phosphors, and a third wavelength conversion region containing blue phosphors, the first to third wavelength conversion regions being disposed above the at least three light emitting diode chips, respectively.

10. The light emitting device according to any one of claims 1 to 9, further comprising:
a UV filter allowing visible light subjected to wavelength conversion by the wavelength conversion layer to pass therethrough while blocking UV light emitted from the light emitting diode chip.

11. A method of using a light emitting device, the light emitting device comprising a UV light emitting diode chip and a wavelength conversion layer converting UV light emitted from the UV light emitting diode chip into visible light through wavelength conversion, the method comprising:
connecting an external power source to the light emitting device, and operating the light emitting diode chip by supplying electric current to the light emitting device such that a current density of 150 A/cm² or more is applied to the light emitting diode chip.

12. The method of claim 11, wherein the light emitting device further comprises a selective reflector disposed between the wavelength conversion layer and the light emitting diode chip, the selective reflector allowing UV light emitted from the light emitting diode chip to pass therethrough while reflecting visible light subjected to wavelength conversion by the wavelength conversion layer.

13. The method of claim 11 or 12, wherein the light emitting device further comprises a UV filter, the UV filter allowing visible light subjected to wavelength conversion by the wavelength conversion layer to pass therethrough while blocking UV light emitted from the light emitting diode chip.
